Europäisches Patentamt

European Patent Office

Office européen des brevets

(19)

(11) Veröffentlichungsnummer : **0 328 594 B1**

# (12) EUROPÄISCHE PATENTSCHRIFT

(45) Veröffentlichungstag der Patentschrift :
28.10.92 Patentblatt 92/44

(51) Int. Cl.⁵ : **H01L 29/91, H01L 31/10**

(21) Anmeldenummer : **88907114.8**

(22) Anmeldetag : **06.08.88**

(86) Internationale Anmeldenummer :
**PCT/DE88/00487**

(87) Internationale Veröffentlichungsnummer :
**WO 89/02162 09.03.89 Gazette 89/06**

(54) **SCHOTTKY-DIODE.**

(30) Priorität : **22.08.87 DE 3728135**

(43) Veröffentlichungstag der Anmeldung :
**23.08.89 Patentblatt 89/34**

(45) Bekanntmachung des Hinweises auf die
Patenterteilung :
**28.10.92 Patentblatt 92/44**

(84) Benannte Vertragsstaaten :
**AT BE CH DE FR GB IT LI LU NL SE**

(56) Entgegenhaltungen :
**Journal of the Physical Society of Japan, volume 42, no. 2, February 1977, (Tokyo Japan) A. Hasegawa et al.: "Energy bandstructures of Gd-Pnictides", pages 492-498 J.Phys. C: Solid St. Phys., volume 13 1980, The Institute of Physics London GB. A.Hasegawa: "Electronic structure of Lamonopnictides", pages 6147-6156**

(56) Entgegenhaltungen :
**Applied Physics letters, vol. 46, no. 9,1 May 1985. Americain Institute of Physics, Woodbury New York US. J.R. Waldrop:"Rare-earth metal Schottky-barrier contacts to GaAs" pages 864-866.**

(73) Patentinhaber :
**FRAUNHOFER-GESELLSCHAFT ZUR FÖRDERUNG DER ANGEWANDTEN FORSCHUNG E.V. Leonrodstrasse 54 W-8000 München 19 (DE)**

(72) Erfinder : **SMITH, Robin 2 Flambard Road Harrow Middlesex HA1 2NA (GB)** Erfinder : **WENNEKERS, Peter Kirchstrasse 47 W-7800 Freiburg (DE)**

(74) Vertreter : **Rackette, Karl, Dipl.-Phys. Dr.-Ing Kaiser-Joseph-Strasse 179 Postfach 1310 W-7800 Freiburg (DE)**

EP 0 328 594 B1

**Beschreibung**

Die Erfindung betrifft eine Schottky-Diode mit einem Substrat aus Gallium-Arsenid, das auf der von einer ersten metallisierten Anschlußkontaktfläche wegweisenden Seite eine dünne Gallium-Arsenid-Schicht aufweist, auf die eine weitere, einen Schottky-Kontakt bildende dünne Schicht aus einer Lanthaniden-Arsen-Verbindung in einer Dicke zwischen etwa 10 und 100 Ångström aufgebracht und mit einer zweiten metallisierten Anschlußkontaktfläche versehen ist.

Eine solche Schottky-Diode ist aus den US-Appl. Phys.Lett., vol.46, No.9, S.864-866 (1985), bekannt. Bei der bekannten Diode wird die Lanthaniden-Arsenverbindung durch ein Einlagern von äußerem Lanthanid-Material in die Grenzschicht des Gallium-Arsenids geschaffen. Die Deckfläche des Kontakts ist aus der seltenen Erde gebildet.

Ausgehend von diesem Stand der Technik liegt der Erfindung die Aufgabe zugrunde, eine Schottky-Diode der eingangs genannten Art zu schaffen, die sich auf einfache Weise in einer Anlage in einem Prozeß mit einer hohen Ausbeute herstellen läßt und die sich durch einen hohen Wirkungsgrad auszeichnet.

Diese Aufgabe wird erfindungsgemäß dadurch gelöst, daß auf der den Schottky-Kontakt bildenden dünnen Schicht eine sehr dünne Deckschicht aus hochleitendem Gallium-Arsenid aufgebracht ist, die die zweite metallisierte Anschlußkontaktfläche der Schottky-Diode trägt.

Vorzugsweise wird als Lanthanid Erbium oder Ytterbium verwendet das in der gleichen Molekularstrahl-Epitaxieanlage aufgebracht wird wie die dünne Gallium-Arsenid-Schicht.

Da die Schicht aus Erbium-Arsenid oder Ytterbium-Arsenid monokristallin und nicht polykristallin ist, ergeben sich gleichmäßigere Leitfähigkeitsverhältnisse und ein günstigeres Reflexionsverhalten der Schottky-Diode für Licht, wenn diese als Photodetektor eingesetzt wird. Die gleichmäßigere Leitfähigkeit führt zu einem besseren Wirkungsgrad. Da die erfindungsgemäße Schottky-Diode ohne Unterbrechung des Herstellungsprozesses in einer Anlage hergestellt werden kann, ergibt sich eine hohe Ausbeute, ohne die Gefahr von Verschmutzungen beim Transport der halbfertigen Bauelemente von einer Anlage zu einer weiteren Anlage für nachfolgende Prozeßschritte.

Zweckmäßige Ausgestaltungen und Weiterbildungen der Erfindung sind in den Unteransprüchen angegeben.

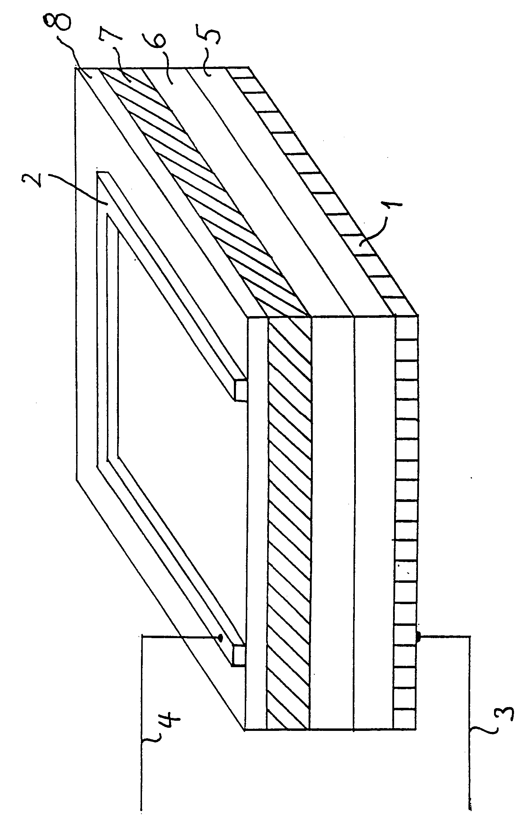

Nachfolgend wird ein Ausführungsbeispiel der Erfindung anhand der Zeichnung, die eine Figur umfaßt, näher beschrieben.

In der Zeichnung erkennt man eine schematisch und perspektivisch dargestellte als Photodetektor einsetzbare Schottky-Diode, deren Dicke gegenüber den übrigen Abmessungen zur Verdeutlichung übertrieben groß dargestellt ist.

Bei der in der Zeichnung dargestellten Schottky-Diode ist die erste Anschlußelektrode als großflächige Metallelektrode 1 ausgebildet, während die zweite Anschlußelektrode, die beim Einsatz als Photodetektor auf der Lichteinfallsseite liegt, als U-förmiger Metallkontaktstreifen 2 ausgebildet ist. Die großflächige Metallelektrode 1 ist mit einem Kontaktdraht 3 und der Metallkontaktstreifen 2 mit einem Kontaktdraht 4 in üblicher Weise verbunden.

Die großflächige Metallelektrode befindet sich auf der Unterseite eines Substrates 5 aus mit Silizium dotiertem elektrisch leitendem Gallium Arsenid. Auf das Substrat 5 aus Gallium-Arsenid ist epitaktisch eine dünne monokristalline Gallium-Arsenid-Schicht 6 mit geringer elektrischer Leitfähigkeit aufgewachsen. Wie das Substrat 5 enthält auch die monokristalline Gallium-Arsenid-Schicht 6 Silizium als Fremdatome.

Die nächste Schicht in der Schichtenfolge der Schottky-Diode besteht aus einer dünnen monokristallin aufgewachsenen Schicht 7 aus Erbium-Arsenid oder aus Ytterbium-Arsenid. Diese Schicht hat die Eigenschaft für Licht mit einer Wellenlänge von weniger als 1 μm ganz transparent zu sein, so daß ein transparenter Schottky-Kontakt gebildet wird. Infolge des monokristallinen Aufbaus ergibt sich eine gleichmäßige Leitfähigkeit und ein günstiges Reflexionsverhalten bei einem Lichteinfall. Somit ergibt sich durch die gleichmäßige Leitfähigkeit ein besonders guter Wirkungsgrad. Die Schicht 7 aus Erbium-Arsenid oder Ytterbium-Arsenid stellt eine elektrisch hochleitende Schicht dar, die die Bildung eines Schottky-Kontaktes gestattet. Sie läßt sich epitaktisch monokristallin auf Gallium-Arsenid aufwachsen und gestattet es, eine weitere sehr dünne elektrisch gut leitende Gallium-Arsenid-Schicht 8 als Deckschicht auf die Schicht 7 aufzubringen, so daß eine monokristalline Folge von Schichten aus Gallium-Arsenid, hochleitender Schicht und Gallium-Arsenid erzeugt wird.

Die Herstellung der Schottky-Diode erfolgt in einer Molekularstrahl-Epitaxieanlage in einem Prozeß, ohne daß das Bauelement während seiner Herstellung in eine getrennte Apparatur eingeführt zu werden braucht.

Zur Herstellung der Schottky-Diode wird das Substrat 5, bei dem es sich um eine ebene Gallium-Arsenid-Scheibe handelt, in einer Molekularstrahl-Epitaxieanlage (MBE-Anlage) auf einen beheizten Scheibenhalter montiert. Im Vakuum erfolgt ein Aufheizen des Substrates 5 auf 550 bis 600°C. Gleichzeitig erfolgt das Aufheizen von hier in der MBE-Anlage vorgesehenen Tiegeln, die jeweils Arsen, Gallium, Silizium und das jeweils verwendete Lanthanid, d.h. z.B. Ytterbium oder Erbium enthalten. Die vier Tiegel sind in üblicher Weise mit Deckeln versehen, die zur Steuerung des Herstellungsprozesses geöffnet und geschlossen werden können.

Zu Beginn des Herstellungsverfahrens wird der Arsenid-Tiegel, danach der Gallium-Tiegel und schließlich der Silizium-Tiegel geöffnet. Beim Kondensieren des aus den Tiegeln austretenden Dampfes an der Oberfläche des Substrates 5 bildet sich die monokristalline Gallium-Arsenid-Schicht 6. Dabei wird das von einem der Tiegel gelieferte Silizium als Fremdatom in die monokristalline Gallium-Arsenid-Schicht 6 eingebaut, so daß die monokristalline Gallium-Arsenid-Schicht 6 elektrisch leitend wird. Die elektrische Leitfähigkeit kann dabei durch Einstellen der Temperatur der Heizung des das Silizium enthaltenden Tiegels wunschgemäß eingestellt werden. Die Dicke der Gallium-Arsenid-Schicht 6 wird durch die Öffnungszeit des Deckels des Gallium enthaltenden Tiegels bestimmt. Die verschiedenen Parameter des Herstellungsprozesses werden so gewählt, daß eine dünne monokristalline Gallium-Arsenid-Schicht 6 mit geringer elektrischer Leitfähigkeit aufwächst. Wenn die erwünschte Dicke erreicht ist, werden die Deckel der Silizium und Gallium enthaltenden Tiegel geschlossen.

Nach dem Öffnen des Lanthanid-Tiegels verdampft das in ihm enthaltene Ytterbium bzw. Erbium langsam, wobei sich auf der Gallium-Arsenid-Schicht 6 eine monokristalline epitaktische Ytterbium-Arsenid- bzw. Erbium-Arsenid-Schicht bildet. Wenn statt der erwähnten Lanthanide andere Lanthanide eingesetzt werden, bilden sich in entsprechender Weise andere Monopniktide.

Die Wachstumsgeschwindigkeit der Schicht 7 hängt von der Temperatur des zugeordneten Tiegels ab und kann somit durch die Temperaturwahl beeinflußt werden. Der Epitaxieprozeß wird beendet, sobald eine dünne, monokristalline Schicht 7 mit einer Dicke von etwa 1-10 nm (10 bis 100 Ångström) entstanden ist. Dazu wird der Lanthanidtiegel geschlossen.

Im Anschluß daran wird zunächst der Gallium-Tiegel der MBE-Anlage und danach der Silizium-Tiegel der MBE-Anlage geöffnet. Auf diese Weise bildet sich die sehr dünne elektrisch gut leitende Gallium-Arsenid-Schicht 8, die als Deckschicht dient. Die Gallium-Arsenid-Schicht 8 wächst monokristallin epitaktisch auf der monokristallinen Schicht 7 aus Ytterbium oder Erbium auf.

Nach dem Aufbringen der zum Schutz der Schicht 7 dienenden Gallium-Arsenid-Schicht 8 kann das in der beschriebenen Weise behandelte Substrat 5 aus der MBE-Anlage herausgenommen werden. Es ist nunmehr lediglich noch erforderlich, in einer Metall-Aufdampfanlage die großflächige Metallelektrode 1 und den Metallkontaktstreifen 2 aufzudampfen sowie die aufgedampften Metallschichten mit den Kontaktdrähten 3 und 4 zu verbinden. Außerdem wird das so erstellte Bauelement in an sich bekannter Weise in ein Gehäuse eingebracht, wobei beim Einsatz der beschriebenen Schottky-Diode als Lichtdetektor auf der Seite des Metallkontaktstreifens 2 ein Lichteinlaßfenster vorgesehen wird.

## Patentansprüche

1. Schottky-Diode mit einem Substrat (5) aus Gallium-Arsenid, das auf der von einer ersten metallisierten Anschlußkontaktfläche (1) wegweisenden Seite eine dünne Gallium-Arsenid-Schicht (6) aufweist, auf die eine weitere, einen Schottky-Kontakt bildende dünne Schicht (7) aus einer Lanthaniden-Arsen-Verbindung in einer Dicke zwischen etwa 1 und 10 nm (10 und 100 Ångström) aufgebracht und mit einer zweiten metallisierten Anschlußkontaktfläche (2) versehen ist, **dadurch gekennzeichnet**, daß auf der den Schottky-Kontakt bildenden dünnen Schicht (7) eine sehr dünne Deckschicht (8) aus hochleitendem Gallium-Arsenid aufgebracht ist, die die zweite metallisierte Anschlußkontaktfläche (2) der Schottky-Diode trägt.

2. Schottky-Diode nach Anspruch 1, dadurch gekennzeichnet, daß die auf das Substrat (5) aufgewachsene monokristalline Gallium-Arsenid-Schicht (6) eine verhältnismäßig geringe elektrische Leitfähigkeit aufweist.

3. Schottky-Diode nach Anspruch 1 oder Anspruch 2, dadurch gekennzeichnet, daß die Schottky-Diode als Photodiode ausgebildet ist, deren zweite metallisierte Anschlußkontaktfläche Metallkontaktstreifen (2) sind.

4. Schottky-Diode nach einem der Ansprüche 1 bis 3, dadurch gekennzeichnet, daß das Lanthanid der Lanthaniden-Arsen-Verbindung Erbium ist.

5. Schottky-Diode nach einem der Ansprüche 1 bis 3, dadurch gekennzeichnet, daß das Lanthanid der Lanthaniden-Arsen-Verbindung Ytterbium ist.

6. Schottky-Diode nach einem der Ansprüche 1 bis 3, dadurch gekennzeichnet, daß die Lanthaniden-Arsen-Verbindung mehrere unterschiedliche Lanthanide enthält.

7. Schottky-Diode nach einem der Ansprüche 1 bis 6, dadurch gekennzeichnet, daß die den Schottky-Kontakt bildende Schicht (7) monokristallin ist.

## Claims

1. A Schottky diode comprising a gallium arsenide substrate (5) which, on the side facing away from a first metallised terminal contact surface (1) has a thin gallium arsenide layer (6) to which a further thin layer (7) comprising a lanthanide arsenic compound and forming a Schottky contact is applied in a thickness of between about 1 and 10 nm (10 and 100 Ångström), and is provided with a second metallised terminal contact surface (2), characterised in that applied to the thin layer (7) forming the Schottky contact is a very thin covering layer (8) of highly conductive gallium arsenide, which carries the second metallised terminal contact surface (2) of the Schottky diode.

2. A Schottky diode according to claim 1 characterised in that the monocrystalline gallium arsenide layer (6) which is grown on to the substrate (5) has a comparatively low level of electrical conductivity.

3. A Schottky diode according to claim 1 or claim 2 characterised in that the Schottky diode is in the form of a photodiode whose second metallised terminal contact surface are metal contact strips (2).

4. A Schottky diode according to one of claims 1 to 3 characterised in that the lanthanide of the lanthanide arsenic compound is erbium.

5. A Schottky diode according to one of claims 1 to 3 characterised in that the lanthanide of the lanthanide arsenic compound is ytterbium.

6. A Schottky diode according to one of claims 1 to 3 characterised in that the lanthanide arsenic compound contains a plurality of different lanthanides.

7. A Schottky diode according to one of claims 1 to 6 characterised in that the layer (7) forming the Schottky contact is monocrystalline.

## Revendications

1. Une diode à barrière de Schottky avec un substrat (5) en arséniure de gallium qui, du côté opposé à une première surface de contact de raccordement métallisée (1), comporte une couche mince d'arséniure de gallium (6) sur laquelle est disposée une autre couche mince (7) d'un composé lanthanide-arsenic d'une épaisseur comprise entre 1 et 10 nm, formant un contact de Schottky, et une seconde surface de contact de raccordement métallisée (2), caractérisée en ce que sur la couche mince formant le contact de Schottky (7), a été disposée une couche de recouvrement très mince (8) d'arséniure de gallium hautement conductrice, qui porte la seconde surface de contact de raccordement métallisée (2) de la diode à barrière de Schottky.

2. Une diode à barrière de Schottky selon la revendication 1, caractérisée en ce que la couche d'arséniure de gallium (6) obtenue par croissance monocristalline sur le substrat (5) montre une conductivité relativement faible.

3. Une diode à barrière de Schottky selon la revendication 1 ou la revendication 2, caractérisée en ce que la diode à barrière de Schottky est constituée comme une photodiode dont la seconde surface de contact de raccordement métallisée est constituée de bandes de contact en métal (2)

4. Une diode à barrière de Schottky selon l'une des revendications 1 à 3, caractérisée en ce que la terre rare du composé lanthanide-arsenic est de l'erbium.

5. Une diode à barrière de Schottky selon l'une des revendications 1 à 3, caractérisée en ce que la terre rare du composé lanthanide-arsenic est de l'ytterbium.

6. Une diode à barrière de Schottky selon l'une des revendications 1 à 3, caractérisée en ce que le composé lanthanide-arsenic contient plusieurs terres rares différentes.

7. Une diode à barrière de Schottky selon l'une des revendications 1 à 6, caractérisée en ce que la couche (7) formant le contact de Schottky est monocristalline.

EP 0 328 594 B1

5